# EUROPÄISCHE PATENTANMELDUNG

(11) **EP 3 719 985 A1**
(43) Veröffentlichungstag der Anmeldung: **07.10.2020**
(21) Anmeldenummer: 20162937.5
(22) Anmeldetag: 13.03.2020
(51) Int. Cl.: H02M 5/293, H05B 6/02, H05B 3/00, G01R 19/00, F24C 7/04, G01R 31/28, H05B 1/02

(54) **HAUSHALTSGERÄT MIT EINER ELEKTRISCHEN FUNKTIONSEINHEIT SOWIE VERFAHREN ZU DEREN BETRIEB**

(30) Priorität: 01.04.2019 DE 102019204528
(71) Anmelder: BSH Hausgeräte GmbH, 81739 München (DE)
(72) Erfinder: Huber, Andreas, 83301 Traunreut (DE)

(57) **Zusammenfassung**

Die Erfindung betrifft ein Verfahren zum Betreiben eines Haushaltsgeräts (1) mit einer elektrischen Funktionseinheit (11, 12, 13, 14), die ein widerstandselektrisches Funktionselement (19, 33, 34, 35, 36) und ein zum Funktionselement in Reihe geschaltetes elektrisches Schaltelement (21, 23, 24, 25, 26) aufweist, einem zweiten Schaltelement (22, 27, 28), das zur elektrischen Funktionseinheit in Reihe geschaltet ist, und einer mit dem ersten und dem zweiten Schaltelement gekoppelten Steuereinheit (9), wobei diese Reihenschaltung mit einer elektrischen Energiequelle elektrisch gekoppelt wird, dadurch gekennzeichnet, dass an einem durch eine elektrische Verbindung der elektrischen Funktionseinheit mit dem zweiten Schaltelement gebildeten Mittelanschluss (30, 31, 32) eine elektrische Spannung erfasst wird, wobei das erste Schaltelement und das zweite Schaltelement in einem vorgebbaren Testzeitraum (41) mit vorgebbaren Schaltsignalen beaufschlagt werden, die sich zeitlich teilweise überlappen, und die erfasste Spannung unter Berücksichtigung der Schaltsignale ausgewertet wird, um die Funktionsfähigkeit der elektrischen Schaltelemente zu bestimmen.

## Beschreibung

Die Erfindung betrifft ein Haushaltsgerät mit einer elektrischen Funktionseinheit, die wenigstens ein widerstandselektrisches Funktionselement und ein zum wenigstens einen Funktionselement in Reihe geschaltetes erstes steuerbares elektrisches Schaltelement aufweist, einem zweiten steuerbaren elektrischen Schaltelement, das zur elektrischen Funktionseinheit in Reihe geschaltet ist, und einer zumindest mit dem wenigstens einen ersten und dem zweiten elektrischen Schaltelement elektrisch gekoppelten Steuereinheit zum Steuern des wenigstens einen ersten und des zweiten elektrischen Schaltelements, wobei die aus der Funktionseinheit und dem zweiten steuerbaren elektrischen Schaltelement gebildete Reihenschaltung mit einer elektrischen Energiequelle elektrisch koppelbar ist. Ferner betrifft die Erfindung ein Verfahren zum Betreiben eines Haushaltsgeräts mit einer elektrischen Funktionseinheit, die wenigstens ein widerstandselektrisches Funktionselement und ein zum wenigstens einen Funktionselement in Reihe geschaltetes erstes steuerbares elektrisches Schaltelement aufweist, einem zweiten steuerbaren elektrischen Schaltelement, das zur elektrischen Funktionseinheit in Reihe geschaltet ist, wobei das wenigstens eine erste und das zweite elektrische Schaltelement mittels einer mit dem wenigstens einen ersten und dem zweiten elektrischen Schaltelement gekoppelten Steuereinheit gesteuert werden, wobei die aus der Funktionseinheit und dem zweiten elektrischen Schaltelement gebildete Reihenschaltung mit einer elektrischen Energiequelle elektrisch gekoppelt wird.

Gattungsgemäße Haushaltsgeräte und Verfahren sind im Stand der Technik umfänglich bekannt. Beispielsweise offenbart die WO 2012/152782 A1 eine Leiterplatte für ein Haushaltsgerät, ein Haushaltsgerät und ein Verfahren zum Betreiben des Haushaltsgeräts. Mittels eines auf der Leiterplatte angeordneten Magnetfeldsensors soll ein Stromfluss eines Strompfads überwacht werden, um defekte Bauteile in einem Stromkreis erkennen zu können. Das defekte Bauteil kann zum Beispiel ein defekter Heizkörper, ein verklebtes Relais, eine Leiterbahnunterbrechung oder dergleichen sein. Darüber hinaus soll eine Stromregelung ermöglicht werden. Diese Lehre ist auf Kochfelder als Haushaltsgeräte gerichtet.

Bei Kochfeldern mit Strahlungsheizkörpern werden üblicherweise die für einen jeweiligen Strahlungsheizkörper vorgesehenen Haupt- und Taktrelais oder deren Ansteuerung überwacht. Zwar kann dies mit der Lehre der WO 2012/152782 A1 dem Grunde nach erreicht werden, jedoch erweist sich der Aufwand zur Realisierung der Überwachungsfunktion als groß. Insbesondere die spezifische Leiterplatte der WO 2012/152782 A1 erfordert nicht nur eine spezifische Konstruktion, die für eine jeweilige Leistung des Strahlungsheizkörpers angepasst ausgebildet sein muss, sondern die Leiterplatte führt auch zu bautechnischen und sicherheitstechnisch erhöhten Anforderungen, die die Baugröße des Kochfelds und die Kosten des Kochfelds negativ beeinflussen können.

Der Erfindung liegt die Aufgabe zugrunde, die Überwachung von Schaltelementen bei gattungsgemäßen Haushaltsgeräten zu verbessern.

Als Lösung werden mit der Erfindung ein Haushaltsgerät sowie ein Verfahren gemäß den unabhängigen Ansprüchen vorgeschlagen.

Vorteilhafte Weiterbildungen ergeben sich durch Merkmale der abhängigen Ansprüche.

In Bezug auf ein gattungsgemäßes Haushaltsgerät wird insbesondere vorgeschlagen, dass an einem durch eine elektrische Verbindung der elektrischen Funktionseinheit mit dem zweiten elektrischen Schaltelement gebildeten Mittelanschluss ein mit der Steuereinheit signaltechnisch gekoppelter Spannungssensor angeschlossen ist, wobei die Steuereinheit ausgebildet ist, in einem vorgebbaren Testzeitraum das wenigstens eine erste steuerbare elektrische Schaltelement und das zweite elektrische Schaltelement mit vorgebbaren Schaltsignalen zu beaufschlagen, die sich zeitlich teilweise überlappen, und ein Sensorsignal des Spannungssensors unter Berücksichtigung der Schaltsignale auszuwerten.

Widerstandselektrische Funktionselemente sind elektrische Einrichtungen beziehungsweise elektrische Einheiten, die dazu dienen, unter Nutzung von elektrischer Energie im Rahmen des Betriebs des Haushaltsgeräts eine gewünschte Funktion im Haushalt, beispielsweise Wärmeenergie oder dergleichen, bereitzustellen. Das Haushaltsgerät kann zum Beispiel ein Herd, beispielsweise ein Backofen, ein Kochfeld, insbesondere ein autarkes Kochfeld, Kombinationen hiervon oder dergleichen, eine Waschmaschine, ein Trockner, eine Geschirrspülmaschine und/oder dergleichen sein. Die elektrische Funktionseinheit ist vorzugsweise eine Komponente des Haushaltsgeräts, die zur Realisierung der bestimmungsgemäßen Funktion elektrische Energie nutzt. Insbesondere kann die Funktionseinheit ein Heizelement sein, welches der Erzeugung von Wärme unter Nutzung von elektrischer Energie dient. Bei einem Backofen kann dies zum Beispiel ein Heizkörper sein, der an einer Backofenmuffel eines Backofens angeordnet ist, um in vorgebbarer Weise einen Innenraum der Backofenmuffel auf eine vorgegebene Temperatur zu beheizen, damit beispielsweise in der Backofenmuffel angeordnete Nahrungsmittel in entsprechender Weise zubereitet werden können. Darüber hinaus kann die Funktionseinheit auch ein Kochfeld oder ein Teil eines Kochfelds umfassen, welches beispielsweise dazu ausgebildet sein kann, um in vorgebbarer Weise Kochgeschirre zu beheizen, um damit vorzugsweise Nahrungsmittel zubereiten zu können. Das Kochfeld kann zum Beispiel ein Heizelement umfassen, welches ein Strahlungsheizkörper, eine Kochplatte, ein Induktionskochstelle und/oder dergleichen sein kann. Bei einer Waschmaschine oder einer Geschirrspülmaschine kann die Funktionseinheit eine Heizeinheit umfassen, die zur Durchführung des gewünschten Reinigungsprozesses für Geschirr oder Wäschestücke beziehungsweise dergleichen vorgesehen ist. Die grundlegenden Funktionen von Haushaltsgeräten sind im Stand der Technik umfänglich bekannt, sodass von weiteren entsprechenden Erläuterungen abgesehen werden kann.

Ein widerstandselektrisches Funktionselement, welches vorzugsweise ein Teil der elektrischen Funktionseinheit sein kann, ist ein Element, nutzt elektrische Energie, um beispielsweise Wärme und/oder elektromagnetische Strahlung zu erzeugen, beispielsweise ein Strahlungsheizkörper eines Kochfelds, eine Induktionsheizung, eine Kochplatte und/oder dergleichen. Das widerstandselektrische Funktionselement zeichnet sich in Bezug auf seine elektrischen Eigenschaften beispielsweise dadurch aus, dass es Eigenschaften aufweist, die mit einem ohmschen Widerstand im Wesentlichen vergleichbar sein können. Natürlich können die Eigenschaften auch je nach tatsächlicher Ausgestaltung des widerstandselektrischen Funktionselements teilweise hiervon abweichen, beispielsweise bei einer Induktionsheizung oder dergleichen, ohne jedoch den wesentlichen Gedanken der Erfindung dadurch zu beeinflussen.

Die elektrische Funktionseinheit umfasst für das widerstandselektrische Funktionselement ein erstes steuerbares elektrisches Schaltelement, welches mit dem widerstandselektrischen Funktionselement in Reihe geschaltet ist. Dadurch wird die elektrische Funktionseinheit gebildet, die in steuerbarer Weise die gewünschte Funktion bereitzustellen vermag, beispielsweise eine vorgebbare Wärmeleistung oder dergleichen. Das Schaltelement dient dazu, das widerstandselektrische Funktionselement in einem Taktbetrieb zu betreiben, indem es in einem Rhythmus eines Schaltsignals einer Steuereinheit des Haushaltsgeräts betrieben wird, sodass das widerstandselektrische Funktionselement entsprechend des Schaltsignals mit der elektrischen Energiequelle gekoppelt wird, um elektrische Energie aus der elektrischen Energiequelle zu erhalten, um die gewünschte Funktion, beispielsweise das Erzeugen von Wärme oder elektromagnetischer Strahlung, zu realisieren. Das erste steuerbare elektrische Schaltelement kann zum Beispiel bei einem Kochfeld ein Taktrelais oder dergleichen sein.

Es ist ferner vorgesehen, dass zur elektrischen Funktionseinheit ein zweites steuerbares elektrisches Schaltelement in Reihe geschaltet ist, welches ebenfalls mit der Steuereinheit gekoppelt ist. Mit dem zweiten steuerbaren elektrischen Schaltelement kann eine zusätzliche Schaltfunktion, beispielsweise die Funktion eines Hauptschalters oder dergleichen, realisiert werden. Darüber hinaus kann mit dem zweiten steuerbaren elektrischen Schaltelement die Sicherheit, insbesondere in Bezug auf die elektrische Sicherheit oder auf die Betriebssicherheit des Haushaltsgeräts insgesamt, verbessert werden. Das zweite elektrische steuerbare Schaltelement kann zum Beispiel als Hauptschalter-Relais ausgebildet sein.

Das Schaltelement kann als elektromechanisches Schaltelement ausgebildet sein, beispielsweise nach Art eines Schützes, eines Relais oder dergleichen. Das Schaltelement kann jedoch auch als elektronisches Schaltelement ausgebildet sein, beispielsweise als Transistor, der in einem Schaltbetrieb betrieben wird, ein Thyristor, Kombinationsschaltungen hiervon, vorzugsweise mit parallelgeschalteten Inversdioden, ein Gate-Turn-Off-Thyristor (GTO), ein Insulated-Gate-Bipolar-Transistor (IGBT), Kombinationen hiervon oder dergleichen. Dem Grunde nach kann das Schaltelement jedoch auch durch einen Feldeffekttransistor, insbesondere einen Metalloxide-Semiconductor-Field-Effect-Transistor (MOSFET) gebildet sein.

Ist das Schaltelement durch ein elektronisches Schaltelement gebildet, und zwar einem Transistor, bedeutet der Schaltbetrieb, dass in einem eingeschalteten Schaltzustand zwischen den eine Schaltstrecke bildenden Anschlüssen des Transistors ein sehr kleiner elektrischer Widerstand bereitgestellt wird, sodass ein hoher Stromfluss bei kleiner Restspannung möglich ist. In einem ausgeschalteten Schaltzustand ist hingegen die Schaltstrecke des Transistors hochohmig, das heißt, sie stellt einen hohen elektrischen Widerstand bereit, sodass auch bei hoher, an der Schaltstrecke anliegender elektrischer Spannung im Wesentlichen kein oder nur ein geringer, insbesondere vernachlässigbarer, Stromfluss vorliegt. Hiervon unterscheidet sich ein Linearbetrieb bei Transistoren, der aber bei Schaltbetrieb in der Regel nicht zum Einsatz kommt.

Die Steuereinheit kann vorzugsweise als eine separate elektronische Baugruppe ausgebildet sein. Darüber hinaus kann die Steuereinheit jedoch auch zumindest teilweise von einer übergeordneten Steuerung des Haushaltsgeräts umfasst sein. Die Steuereinheit kann eine Hardwareschaltung und/oder eine Rechnereinheit umfassen. Die Rechnereinheit ist programmgesteuert. Die Rechnereinheit kann eine eigene Speichereinheit zumindest teilweise umfassen oder an eine solche angeschlossen sein, in der ein entsprechende Steuerbefehle umfassendes Rechnerprogramm gespeichert ist. Die Speichereinheit kann auch separiert von der Rechnereinheit ausgebildet sein. Bei Aktivierung des Rechnerprogramms führt die Rechnereinheit die Steuerbefehle aus, damit die Steuereinheit zumindest eine Verfahrensführung gemäß der Erfindung realisiert. Das Rechnerprogramm kann zu diesem Zweck auch von einem Datenträger und/oder über ein Kommunikationsnetzwerk von einer Datenquelle bereitgestellt werden. Die Steuereinheit ist ausgebildet, zum Bereitstellen der Funktionalität des Haushaltsgeräts für die Schaltelemente erforderlichen Schaltsignale bereitzustellen. Auch weitere Funktionen, insbesondere in Bezug auf den bestimmungsgemäßen Betrieb des Haushaltsgeräts beziehungsweise einer jeweiligen Funktionseinheit, können durch die Steuereinheit realisiert sein, beispielsweise Überwachungsfunktionen, Sicherheitsfunktionen und/oder dergleichen, wie zum Beispiel Überwachen einer Temperatur der Funktionseinheit, eines Mediums, das mittels der Funktionseinheit erwärmt wird, und/oder dergleichen. Natürlich kann die Steuereinheit als separate Baugruppe ausgebildet sein.

Das Schaltsignal kann ein binäres Schaltsignal sein, welches zwei Zustandswerte einnehmen kann, um die gewünschte Schaltfunktion des Schaltelements bereitstellen zu können. Das Schaltsignal kann ein Spannungssignal oder auch ein Stromsignal sein. Beispielsweise kann das Schaltsignal durch eine Impulsfolge gebildet sein, mittels der ein Steueranschluss des Schaltelements beaufschlagt wird. Dies ist vor allem bei Schaltelementen zweckmäßig, die Thyristoren und GTO umfassen. Darüber hinaus kann bei Transistoren als Schaltelemente vorgesehen sein, dass das Schaltsignal ein Rechtecksignal ist, wobei ein jeweiliger Schaltzustand des Schaltelements beziehungsweise des Transistors einem der zwei Potentiale des Rechtecksignals zugeordnet werden kann. Ein solches Signal ist beispielsweise für Transistoren, insbesondere bipolare Transistoren, Feldeffekttransistoren oder dergleichen zweckmäßig.

Die vorgenannten Realisierungsmöglichkeiten von Schaltelementen können sich sowohl auf das wenigstens eine erste steuerbare elektrische Schaltelement als auch auf das zweite steuerbare elektrische Schaltelement beziehen. Insbesondere können natürlich sowohl das erste als auch das zweite steuerbare elektrische Schaltelement entsprechend ausgebildet sein. Die Schaltelemente können dem Grunde nach von gleicher Art sein. Natürlich können die Schaltelemente auch unterschiedlicher Art sein, sodass zum Beispiel das erste steuerbare elektrische Schaltelement durch ein elektronisches Schaltelement und das zweite steuerbare elektrische Schaltelement durch ein Relais gebildet sein kann. Natürlich können hier auch beliebige andere Kombinationen vorgesehen sein, ohne den Gedanken der Erfindung zu verlassen.

Die aus der Funktionseinheit und dem zweiten steuerbaren elektrischen Schaltelement gebildete Reihenschaltung ist mit einer elektrischen Energiequelle koppelbar. Die elektrische Energiequelle ist vorzugsweise ein öffentliches Energieversorgungsnetz, welches zum Zwecke der Energieversorgung eine einphasige oder auch eine mehrphasige elektrische Wechselspannung bereitstellt. Darüber hinaus kann bei spezifischen Anwendungen auch vorgesehen sein, dass die Energiequelle eine Gleichspannung bereitstellt. Für den Grundgedanken der Erfindung ist es jedoch nicht relevant, ob es sich bei der Energiequelle um eine Energiequelle handelt, die eine Wechselspannung oder eine Gleichspannung bereitstellt.

Die Erfindung beruht unter anderem auf dem Gedanken, dass durch die Reihenschaltung des widerstandselektrischen Funktionselements mit den wenigstens einen ersten und dem zweiten steuerbaren elektrischen Schaltelementen eine einfache Prüfmöglichkeit bereitgestellt werden kann, mit der festgestellt werden kann, ob die Schaltelemente im bestimmungsgemäßen Betrieb die gewünschte Funktion bereitzustellen vermögen. Insbesondere erlaubt es die Erfindung festzustellen, ob eines oder mehrere der Schaltelemente defekt sind und somit der bestimmungsgemäße Betrieb des Haushaltsgeräts beeinträchtigt sein kann. Mit der Erfindung ist es daher vorzugsweise möglich, die Funktionsfähigkeit der Schaltelemente zu bestimmen. Alternativ oder ergänzend kann auch die Funktionsfähigkeit einer Ansteuerung beziehungsweise Ansteuerschaltung, die zumindest teilweise von der Steuereinheit umfasst sein kann, bestimmt werden.

Zu diesem Zweck ist vorgesehen, dass an einem durch eine elektrische Verbindung der elektrischen Funktionseinheit mit dem zweiten steuerbaren elektrischen Schaltelement gebildeten Mittelanschluss ein mit der Steuereinheit signaltechnisch gekoppelter Spannungssensor angeschlossen ist. Mittels des Spannungssensors kann eine elektrische Spannung am Mittelanschluss erfasst werden, wobei der Spannungssensor ein entsprechendes Sensorsignal, beispielsweise ein Spannungssignal, an die Steuereinheit übermittelt. Das Spannungssignal kann beispielsweise ein Analogsignal oder auch ein digitales Signal sein, abhängig von der Konstruktion des Spannungssensors.

Die Steuereinheit kann das vom Spannungssensor bereitgestellte Sensorsignal auswerten, und zwar unter Berücksichtigung der Schaltsignale für die elektrischen Schaltelemente, um dadurch insbesondere die Funktionsfähigkeit der elektrischen Schaltelemente und/oder deren Ansteuerung zu bestimmen. Zu diesem Zweck können beispielsweise als Referenz dienende Signalverläufe insbesondere lokal gespeichert sein, beispielsweise in einer entsprechenden Speichereinheit, die mit der Steuereinheit in Kommunikationsverbindung steht oder von der Steuereinheit zumindest teilweise umfasst ist, oder von einer entfernten Datenbank über eine Kommunikationsverbindung abgerufen werden. Zu diesem Zweck ist ferner ein vorgebbarer Testzeitraum vorgesehen, in dem die Steuereinheit das wenigstens eine erste steuerbare elektrische Schaltelement und das zweite steuerbare elektrische Schaltelement mit vorgebbaren Schaltsignalen beaufschlägt, die sich zeitlich teilweise überlappen. Durch diese spezifische Bereitstellung von Schaltsignalen kann durch Auswerten des Sensorsignals ermittelt werden, ob eines oder mehrere der elektrischen Schaltelemente beschädigt sind oder nicht.

Für die Realisierung der Erfindung ist es also lediglich erforderlich, bei einer bestehenden Schaltungsanordnung des Haushaltsgeräts zusätzlich einen Spannungssensor vorzusehen und eine entsprechende Auswertemöglichkeit durch die Steuereinheit bereitzustellen. Besonders, wenn die Steuereinheit zumindest teilweise eine programmgesteuerte Rechnereinheit umfasst, kann daher die Erfindung auf einfache Weise realisiert, insbesondere sogar nachgerüstet werden. Dabei erweist sich der erforderliche Aufwand, um die Erfindung zu realisieren, als vergleichsweise gering gegenüber Lösungen, die aus dem Stand der Technik bekannt sind.

Die Erfindung ermöglicht es also, mit vergleichsweise geringem Schaltungsaufwand eine Erfassung von kritischen Zuständen der elektrischen Schaltelemente zu realisieren. Dabei kann vorgesehen sein, dass nicht nur eine Fehlansteuerung, sondern auch ein Ausfall beziehungsweise eine Störung eines elektrischen Schaltelements erkannt werden kann. Darüber hinaus ergibt sich auch in Bezug auf die Sicherheit ein Vorteil, weil gerade bei beispielsweise Kochfeldern das elektrische Schaltelement, welches die Funktion des Lastschalters bereitstellt, nicht mehr überwacht zu werden braucht. Die hierdurch freiwerdenden Ressourcen können beispielsweise dazu genutzt werden, die als Hauptschalter vorgesehenen zweiten steuerbaren Schaltelemente unabhängig voneinander mittels eigener Schaltsignale getrennt ansteuern zu können. Dies hat den Vorteil, dass im Falle, dass eine Störung ermittelt worden ist, nicht das gesamte Haushaltsgerät abgeschaltet zu werden braucht. Es ist dann möglich, lediglich den betroffenen Pfad zu deaktivieren beziehungsweise abzuschalten. Weitere Funktionseinheiten, die von der Störung nicht betroffen sind, können somit weiterbetrieben werden. Dies ist nicht nur aber besonders bei zum Beispiel Kochfeldern vorteilhaft.

Der Testzeitraum ist ein Zeitraum, der für die Durchführung der Prüfungsfunktion gemäß der Erfindung vorgegeben werden kann. Der Testzeitraum kann beispielsweise bei einem Einschalten oder auch bei einem Ausschalten des Haushaltsgeräts ausgeführt werden. Dem Grunde nach besteht aber auch die Möglichkeit, den Testzeitraum während des bestimmungsgemäßen Betriebs einzufügen und insbesondere den bestimmungsgemäßen Betrieb für die Dauer des Testzeitraums zu unterbrechen. Der Testzeitraum kann ein zeitlich kurz bemessener Zeitraum sein, der beispielsweise eine oder mehrere Sekunden umfassen kann. Je nach Auslegung der Steuereinheit kann der Testzeitraum jedoch auch deutlich kürzer sein, beispielsweise mehrere Millisekunden umfassen oder dergleichen. Für die Vorgabe des Testzeitraums kann auch berücksichtigt werden, um welche Art von elektrischen Schaltelementen es sich handelt. Sind beispielsweise Transistoren oder Thyristoren als elektrische Schaltelemente vorgesehen, kann ein besonders kurzer Testzeitraum vorgesehen sein, der beispielsweise lediglich wenige Millisekunden umfasst. Sind hingegen elektromechanische Schaltelemente als elektrische Schaltelemente umfasst, kann es zweckmäßig sein, Schalteigenschaften und Schaltgeschwindigkeiten dieser elektromechanischen Schaltelemente bei der Auslegung des Testzeitraums sowie auch der Bestimmung der Schaltsignale während des Testzeitraums zu berücksichtigen.

Die Erfindung erlaubt es darüber hinaus, die elektrischen Schaltelemente hinsichtlich ihrer Sicherheitsreserven geringer zu dimensionieren und dadurch kostengünstiger zu gestalten, weil etwaige Fehler beziehungsweise Störungen eines jeweiligen Schaltelements mittels der Erfindung zuverlässig erkannt werden können, sodass das Haushaltsgerät zumindest in einem betroffenen Pfad zuverlässig abgeschaltet werden kann. Dies ist besonders dann von Vorteil, wenn das widerstandselektrische Funktionselement beziehungsweise die Funktionseinheit nicht eigensicher sind.

Es wird ferner vorgeschlagen, dass der Spannungssensor ausgebildet ist, eine elektrische Spannung zwischen dem Mittelanschluss und einem vorgebbaren elektrischen Bezugspotential zu erfassen, wobei das elektrische Bezugspotential vorzugsweise durch eines von wenigstens zwei elektrischen Potentialen eines Energiequellenanschlusses zum elektrischen Koppeln der Energiequelle gebildet ist. Der Energiequellenanschluss ist insbesondere ein Element des Haushaltsgeräts. Vorzugsweise ist die Reihenschaltung aus der Funktionseinheit und dem zweiten steuerbaren Schaltelement am Energiequellenanschluss des Haushaltsgeräts angeschlossen. Der Energiequellenanschluss ist vorzugsweise ein lösbarer Anschluss, der es erlaubt, das Haushaltsgerät elektrisch mit der Energiequelle, beispielsweise einem öffentlichen Energieversorgungsnetz oder dergleichen, elektrisch zu lösbar verbinden. Das Bezugspotential kann beispielsweise ein Massepotential des Haushaltsgeräts sein. Bei spezifischen Konstruktionen des Haushaltsgeräts beziehungsweise Anschlussbedingungen könnte das Bezugspotential jedoch auch mit einem Erdpotential elektrisch verbunden sein. Beispielsweise kann bei einer Energiequelle, die eine Wechselspannung bereitstellt, ein Nullpotential als Bezugspotential genutzt werden. Dem Grunde nach kann jedoch ein Phasenpotential der Wechselspannung als Bezugspotential genutzt werden. Das Gleiche kann dem Grunde nach auch für eine Energiequelle vorgesehen sein, die eine Gleichspannung bereitstellt. Dadurch kann auf einfache Weise zuverlässig eine Spannung am Mittelanschluss erfasst werden.

Darüber hinaus kann vorgesehen sein, dass der Spannungssensor einen wenigstens zwei elektrische Widerstände aufweisenden Spannungsteiler umfasst. Dadurch kann die erfasste Spannung auf ein durch die Steuereinheit verarbeitbares Niveau transformiert werden. Diese Ausgestaltung eignet sich vorzugsweise für den Fall, dass die durch die elektrische Energiequelle bereitgestellte Spannung und damit auch die am Mittelanschluss erfassbare elektrische Spannung deutlich größer sein kann, als eine Betriebsspannung für die Steuereinheit. Insgesamt kann durch eine sehr einfache und kostengünstige Schaltungsanordnung eine geeignete Anpassung zur Auswertung des Sensorsignals erreicht werden.

Es wird ferner vorgeschlagen, dass die Funktionseinheit wenigstens zwei widerstandselektrische Funktionselemente und zu jedem der wenigstens zwei Funktionselemente ein jeweiliges in Reihe geschaltetes erstes steuerbares elektrisches Schaltelement aufweist, wobei die hierdurch gebildeten Reihenschaltungen parallelgeschaltet sind. Diese Weiterbildung bezieht sich auf Funktionseinheiten, bei denen mehr als lediglich ein einziges widerstandselektrisches Funktionselement vorgesehen ist, beispielsweise bei mehrkreisigen Strahlungsheizkörpern oder dergleichen, oder auch bei Haushaltsgeräten, bei denen zwei oder mehrere widerstandselektrische Funktionselemente im bestimmungsgemäßen Betrieb parallel, beispielsweise unabhängig voneinander, betrieben werden können, zum Beispiel wenn die Funktionseinheit zwei Heizelemente umfasst, die hinsichtlich ihrer elektrischen Leistung mittels des jeweils zugeordneten ersten steuerbaren elektrischen Schaltelements unterschiedlich voneinander, beispielsweise unabhängig voneinander, eingestellt werden können. Derartige Konstellationen können insbesondere bei Kochfeldern auftreten. Durch die Parallelschaltung der Reihenschaltungen kann erreicht werden, dass die Funktionseinheit weiterhin lediglich mit einem einzigen zweiten steuerbaren elektrischen Schaltelement in Reihe geschaltet zu werden braucht. Besonders vorteilhaft ist diese Ausgestaltung bei Kochfeldern einsetzbar, die mit wenigstens zwei Phasen eines mehrphasigen Wechselspannungsnetzes als Energiequelle elektrisch versorgt werden, wobei beispielsweise das Kochfeld vier Heizelemente aufweist, von denen jeweils zwei eine Funktionseinheit bilden und die beiden hierdurch gebildeten Funktionseinheiten an unterschiedlichen Phasen des Wechselspannungsnetzes der Energiequelle angeschlossen sind. Dies ist jedoch nicht hierauf beschränkt.

Darüber hinaus wird vorgeschlagen, dass das Haushaltsgerät wenigstens zwei elektrische Funktionseinheiten aufweist, wobei zu jeder der wenigstens zwei elektrischen Funktionseinheiten ein jeweiliges zweites steuerbares elektrisches Schaltelement in Reihe geschaltet ist. Vorzugsweise ist das jeweilige zweite steuerbare elektrische Schaltelement der jeweiligen Funktionseinheit zugeordnet. Dadurch können die Funktionseinheiten unabhängig voneinander aktiviert beziehungsweise deaktiviert werden. Eine derartige Ausgestaltung findet sich beispielsweise bei Kochfeldern, wie zuvor bereits erläutert. Besonders, wenn die Funktionseinheiten an unterschiedliche Phasen eines Wechselspannungsnetzes der Energiequelle angeschlossen sind, erweist sich diese Ausgestaltung als vorteilhaft. Die Ausgestaltung ist jedoch nicht hierauf beschränkt. Es kann auch vorgesehen sein, dass die Funktionseinheiten gemeinsam von der Energiequelle, beispielsweise einer einzigen Phase des Wechselspannungsnetzes der Energiequelle, versorgbar sind. Eine derartige Ausgestaltung findet sich zum Beispiel bei Kochfeldern, die bei älteren elektrischen Hausinstallationen angeschlossen werden, bei denen für ein Kochfeld lediglich eine einzige Phase des Wechselspannungsnetzes der Energiequelle zur Verfügung steht. Bei neueren Hausinstallationen ist hingegen in der Regel für ein Kochfeld eine dreiphasige elektrische Energieversorgung vorgesehen, sodass die Belastung des Energieversorgungsnetzes beziehungsweise der Energiequelle besser verteilt werden kann.

Ferner wird vorgeschlagen, dass der Spannungssensor ausgebildet ist, an jeweiligen Mittelanschlüssen der durch die jeweiligen Funktionseinheiten und die jeweiligen zweiten steuerbaren elektrischen Schaltelementen gebildeten Reihenschaltungen die jeweiligen elektrischen Spannungen zu erfassen. Der Spannungssensor ist hierfür entsprechend ausgebildet und kann entsprechende elektrische Anschlüsse für die jeweiligen Mittelanschlüsse bereitstellen, sodass die jeweiligen Spannungen an den jeweiligen Mittelanschlüssen erfasst werden können. Zu diesem Zweck kann vorgesehen sein, dass der Spannungssensor vorzugsweise für jeden der Mittelanschlüsse separate Erfassungszweige aufweist, die jeweilige Sensorsignale bezüglich der Mittelanschlüsse bereitstellen. Beispielsweise kann vorgesehen sein, dass jeder Erfassungszweig einen - wie zuvor erläutert - Spannungsteiler umfasst. Das Sensorsignal kann in diesem Fall beispielsweise entsprechend der Anzahl der erfassten Spannungen ausgebildet sein, sodass der Steuereinheit die entsprechenden Informationen zur Verfügung gestellt werden können. Darüber hinaus besteht auch natürlich die Möglichkeit, insbesondere bei einer digitalen Signalübertragung ein Sensorsignal im Zeitmultiplex bereitzustellen, mittels dem die erfassten Spannungen an die Steuereinheit übermittelt werden können. Dadurch kann auf einfache Weise die Überwachung einer Mehrzahl von Funktionseinheiten mit entsprechenden elektrischen Schaltelementen erreicht werden.

Vorzugsweise weist der Spannungssensor zum Erfassen der jeweiligen Spannungen jeweilige an die jeweiligen Mittelanschlüsse mit dem jeweiligen Erfassungsanschluss angeschlossene Erfassungszweige auf, wobei die Erfassungszweige jeweils wenigstens eine Diode umfassen. Die Erfassungszweige sind vorzugsweise identisch aufgebaut. Durch die Dioden kann erreicht werden, dass die jeweiligen Sensorsignale lediglich in einer einzigen Polarität zur Verfügung stehen. Dies ist vorteilhaft für die Auswertung durch die Steuereinheit.

Weiterhin wird vorgeschlagen, dass die Erfassungszweige an den jeweiligen Erfassungsanschlüssen gegenüberliegenden Anschlüssen elektrisch miteinander gekoppelt sind. Dies erlaubt es, ein Sensorsignal zu generieren, welches Informationen bezüglich der erfassten Spannungen an den jeweiligen Mittelanschlüssen bereitzustellen vermag. Dabei erweist es sich als vorteilhaft, dass die Erfassungszweige Dioden aufweisen, weil dadurch erreicht werden kann, dass Rückwirkungen zwischen den Mittelanschlüssen über die Erfassungszweige vermieden werden können. In Verbindung mit einer geeigneten Erzeugung der Schaltsignale durch die Steuereinheit kann somit mit besonders geringem Aufwand eine zuverlässige Auswertung durch die Steuereinheit realisiert werden, die insbesondere sämtliche elektrische Schalteinheiten umfassen kann. Die Aufgabe wird insbesondere auch gelöst durch ein gattungsgemäßes Verfahren, bei dem an einem durch eine elektrische Verbindung der elektrischen Funktionseinheit mit dem zweiten elektrischen Schaltelement gebildeten Mittelanschluss eine elektrische Spannung erfasst wird, wobei das wenigstens eine erste steuerbare elektrische Schaltelement und das zweite elektrische Schaltelement in einem vorgebbaren Testzeitraum mit vorgebbaren Schaltsignalen beaufschlagt werden, die sich zeitlich teilweise überlappen, und die erfasste elektrische Spannung unter Berücksichtigung der Schaltsignale ausgewertet wird. Somit kann zum Beispiel ein zuverlässiges Überwachen der elektrischen Schaltelemente erreicht werden. Darüber hinaus kann auch die Funktionsfähigkeit einer Ansteuerung beziehungsweise Ansteuerschaltung, die zumindest teilweise von der Steuereinheit umfasst sein kann, bestimmt werden. Die Steuereinheit stellt den Testzeitraum bereit, innerhalb dessen sie entsprechende Schaltsignale für das wenigstens eine erste und für das zweite steuerbare elektrische Schaltelement bereitstellt. Abhängig von der durch den Spannungssensor am Mittelanschluss erfassten Spannung unter Berücksichtigung der Sensorsignale kann die Steuereinheit also ermitteln, welche Funktion das jeweilige Schaltelement realisiert. Dadurch ist es der Steuereinheit möglich zu ermitteln, ob das jeweilige elektrische Schaltelement den vorgesehenen Betrieb bestimmungsgemäß realisiert oder nicht. Dadurch können Störungen beziehungsweise Defekte insbesondere in Bezug auf die Schaltelemente und/oder die Ansteuerung ermittelt werden.

Vorzugsweise wird die elektrische Spannung zwischen dem Mittelanschluss und einem vorgebbaren elektrischen Bezugspotential, insbesondere einem von wenigstens zwei elektrischen Potentialen der Energiequelle, erfasst. Dadurch ist es möglich, auf einfache Weise eine reproduzierbare zuverlässige Spannungserfassung durch den Spannungssensor zu realisieren. Das Bezugspotential kann - wie zuvor bereits erläutert - ein Massepotential des Haushaltsgeräts sein. Bei spezifischen Anwendungen könnte das Bezugspotential jedoch auch ein Erdpotential sein. Vorzugsweise ist es jedoch ein elektrisches Potential der elektrischen Energiequelle, und zwar eines derjenigen elektrischen Potentiale der Energiequelle, die mit der Funktionseinheit beziehungsweise dem steuerbaren elektrischen Schaltelement elektrisch verbunden sind.

Gemäß einer Weiterbildung wird vorgeschlagen, dass die Funktionseinheit wenigstens zwei widerstandselektrische Funktionselemente und zu jedem der wenigstens zwei Funktionselemente ein jeweiliges in Reihe geschaltetes erstes steuerbares elektrisches Schaltelement aufweist, wobei die hierdurch gebildeten Reihenschaltungen parallelgeschaltet sind, wobei die Schaltsignale für die wenigsten zwei ersten steuerbaren elektrischen Schaltelemente zeitlich voneinander beabstandet sind. Dadurch ist es möglich, die jeweiligen ersten steuerbaren elektrischen Schaltelemente unabhängig voneinander hinsichtlich ihrer Funktion zu prüfen. Der Testzeitraum erstreckt sich somit vorzugsweise über die Bereitstellung der entsprechenden Schaltsignale für die wenigstens zwei ersten steuerbaren elektrischen Schaltelemente durch die Steuereinheit.

Es wird ferner vorgeschlagen, dass die wenigstens zwei elektrischen Funktionseinheiten getrennt voneinander mit elektrischer Energie versorgt werden. Sie brauchen bei einer mehrphasigen Energiequelle somit nicht durch die gleiche Phase der Energiequelle versorgt zu werden.

Weiterhin wird vorgeschlagen, dass das Haushaltsgerät wenigstens zwei elektrische Funktionseinheiten aufweist, wobei zu jeder der wenigstens zwei elektrischen Funktionseinheiten ein jeweiliges zweites steuerbares elektrisches Schaltelement in Reihe geschaltet ist, mittels welchem die jeweilige Funktionseinheit gesteuert wird. Dadurch ist es möglich, die Funktionseinheiten unabhängig voneinander mit der elektrischen Energiequelle zu koppeln oder nicht. Darüber hinaus erlaubt es diese Ausgestaltung, dass die Funktionseinheiten mit unterschiedlichen Phasen bei einem mehrphasigen Wechselspannungsnetz der Energiequelle voneinander gekoppelt werden können. Dies erlaubt es, die durch die Funktionseinheiten benötige elektrische Energie besser auf die Energiequelle zu verteilen. Zugleich kann die elektrische Sicherheit weiter verbessert werden. Besonders vorteilhaft können die zweiten steuerbaren elektrischen Schaltelemente unabhängig voneinander mittels eigener separater Schaltsignale durch die Steuereinheit gesteuert werden.

Darüber hinaus wird vorgeschlagen, dass der Spannungssensor die an den Mittelanschlüssen erfassten Spannungen voneinander elektrisch entkoppelt erfasst. Dadurch kann der Spannungssensor vorzugsweise eine einheitliche einzige Baugruppe sein, die zugleich zur Spannungserfassung an vorzugsweise allen Mittelanschlüssen, zumindest jedoch an mehreren der Mittelanschlüssen, geeignet ist. Vorzugsweise stellt der Spannungssensor ein entsprechendes Sensorsignal für die Steuereinheit bereit, sodass die Steuereinheit durch Auswerten des Sensorsignals unter Berücksichtigung der jeweils bereitgestellten Schaltsignale die Funktion der entsprechenden elektrischen Schaltelemente ermitteln kann. Dadurch kann die Erfindung auf einfache Weise mit geringem Aufwand realisiert und insbesondere auch bei bereits bestehenden Haushaltsgeräten nachgerüstet werden. Der Spannungssensor kann dem Grunde nach jedoch auch zumindest teilweise von der Steuereinheit umfasst sein.

Schließlich wird vorgeschlagen, dass der bestimmungsgemäße Betrieb des Haushaltsgeräts während des Testzeitraums unterbrochen ist. Diese Ausgestaltung eignet sich insbesondere für den Fall, dass der Testzeitraum während des bestimmungsgemäßen Betriebs des Haushaltsgeräts vorgesehen sein soll. Durch die Unterbrechung des bestimmungsgemäßen Betriebs besteht somit die Möglichkeit, auf einfache Weise und vorzugsweise in einem kurzen Zeitraum den bestimmungsgemäßen Betrieb beziehungsweise die Funktionstüchtigkeit der elektrischen Schaltelemente zu ermitteln beziehungsweise zu bestimmen. Dem Grunde nach reicht es aus, einen einzigen Testzeitraum vorzusehen. Je nach Bedarf können jedoch auch zwei oder mehrere Testzeiträume vorgesehen sein, die in geeigneter Weise zeitlich voneinander beabstandet sind. So kann vorgesehen sein, dass der Testzeitraum beispielsweise zu Beginn eines bestimmungsgemäßen Betriebs des Haushaltsgeräts vorgesehen ist. Ebenso kann der Testzeitraum auch zum Ende eines bestimmungsgemäßen Betriebs des Haushaltsgeräts vorgesehen sein. Darüber hinaus können auch ein oder mehrere Testzeiträume während des bestimmungsgemäßen Betriebs vorgesehen sein, die in geeigneter Weise zeitlich zueinander beabstandet sind. Der zeitliche Abstand zwischen zwei zeitlich aufeinanderfolgenden Testzeiträumen kann beispielsweise mehrere Minuten betragen, insbesondere eine halbe Stunde, eine Stunde oder auch mehr.

Die für das erfindungsgemäße Haushaltsgerät angegebenen Vorteile und Wirkungen gelten natürlich gleichermaßen auch für das erfindungsgemäße Verfahren sowie auch umgekehrt. Insbesondere können für Vorrichtungsmerkmale auch Verfahrensmerkmale und umgekehrt formuliert sein.

Weitere Merkmale der Erfindung ergeben sich aus den Ansprüchen, den Figuren und der Figurenbeschreibung. Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen verwendbar, ohne den Rahmen der Erfindung zu verlassen. Es sind somit auch Ausführungen von der Erfindung als umfasst und offenbart anzusehen, die in den Figuren nicht explizit gezeigt und erläutert sind, jedoch durch separierte Merkmalskombinationen aus den erläuterten Ausführungen hervorgehen und erzeugbar sind. Es sind auch Ausführungen und Merkmalskombinationen als offenbart anzusehen, die somit nicht alle Merkmale des ursprünglich formulierten unabhängigen Anspruchs aufweisen. Es sind darüber hinaus Ausführungen und Merkmalskombinationen, insbesondere durch die oben dargelegten Ausführungen, als offenbart anzusehen, die über die in den Rückbezügen der Ansprüche dargelegten Merkmalskombinationen hinausgehen oder hiervon abweichen.

In den Figuren bezeichnen gleiche Bezugszeichen gleiche Merkmale und Funktionen.

Es zeigen:
- Fig. 1: in einer schematischen perspektivischen Ansicht einen Herd, der ein Kochfeld und einen Backofen umfasst,
- Fig. 2: in einer schematischen Schaltbilddarstellung einen elektrischen Aufbau einer Kochzone des Kochfelds gemäß Fig. 1 sowie eine Steuereinheit und einen Spannungssensor,
- Fig. 3: in einer schematischen Schaltbilddarstellung wie Fig. 2 einen elektrischen Aufbau von drei der vier Kochzonen des Kochfelds gemäß Fig. 1, und
- Fig. 4: eine schematische Signaldarstellung von Signalverläufen zum Bestimmen von Funktionen von Schaltelementen der Kochzonen gemäß Fig. 3.

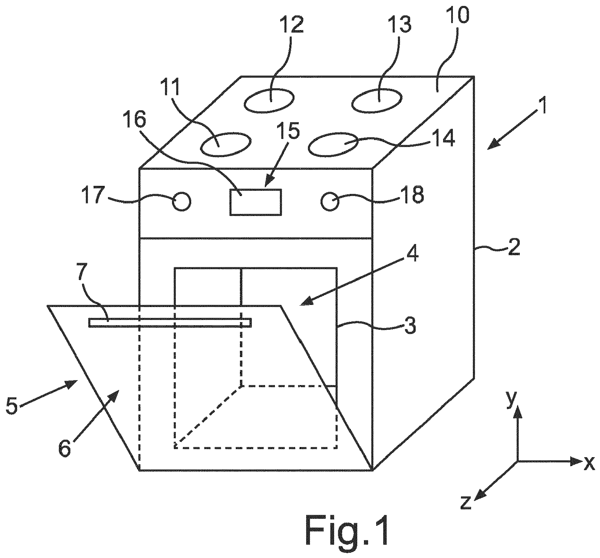

Fig. 1 zeigt in einer perspektivischen Darstellung einen Herd 1 als Haushaltsgerät, welcher als Gargerät ausgebildet ist. Der Herd 1 umfasst ein Gehäuse 2, in dem eine Muffel eines Backofens 4 angeordnet ist, in die Lebensmittel zum Zubereiten eingebracht werden können.

Der Backofen 4 und insbesondere die Muffel 3 sind frontseitig mit einer Beschickungsöffnung ausgebildet, die durch eine Tür 5 verschließbar ist. Die Tür 5 umfasst in dem Ausführungsbeispiel eine Frontscheibe 6, an deren Außenseite ein Türgriff 7 ausgebildet ist. Die Tür 5 umfasst darüber hinaus eine nicht bezeichnete und nicht dargestellte Innenscheibe, die sich parallel zur Frontscheibe 6 erstreckt.

Der Herd 1 umfasst darüber hinaus beispielhaft ein Kochfeld 10, welches in der vorliegenden Ausgestaltung vier Kochzonen 11, 12, 13 und 14 umfasst. Die Kochzonen 11, 12, 13, 14 sind ausgebildet, dass ein jeweiliges Kochgeschirr auf ihnen aufgestellt werden kann, welches durch die Kochzonen 11, 12, 13, 14 erwärmt werden kann, um auf diese Weise in den jeweiligen Kochgeschirren befindliche Lebensmittel zubereiten zu können.

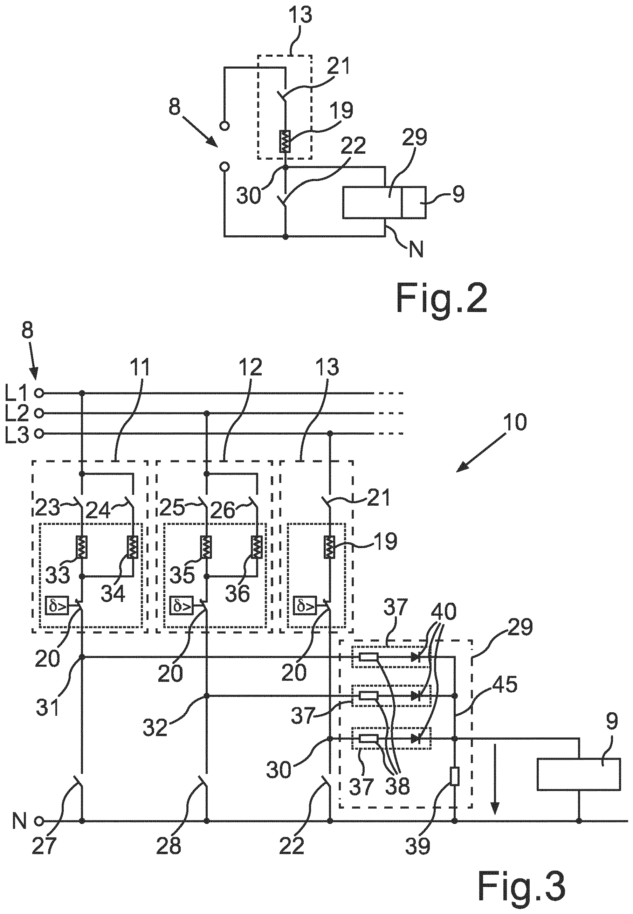

Der Herd 1 umfasst ferner eine Bedienvorrichtung 15 mit einer Anzeigeeinheit 16 sowie Bedienelementen 17 und 18, die der Bedienung des Backofens 4 sowie der Kochzonen 11, 12, 13 und 14 dienen. Diese Elemente sind an eine Steuereinheit 9 (Fig. 2) des Herds 1 angeschlossen, sodass die Steuereinheit 9 den Backofen 4 und die Kochzonen 11, 12, 13 und 14 entsprechend steuern kann.

In der vorliegenden Ausgestaltung ist vorgesehen, dass das Kochfeld 10 als Strahlungskochfeld ausgebildet ist und die Kochzonen 11, 12, 13, 14 durch jeweilige in Fig. 1 nicht dargestellte Strahlungsheizkörper gebildet sind, die widerstandselektrische Funktionselemente beziehungsweise Heizelemente bilden. Die Funktion von Strahlungsheizkörpern zum Erwärmen von Kochgeschirren in Kochfeldern ist dem Grunde nach bekannt, weshalb von entsprechenden Ausführungen an dieser Stelle abgesehen wird. Alternative oder ergänzend können natürlich auch andere Heizelemente wie zum Beispiel Kochplatten, Induktionskochstellen und/oder dergleichen vorgesehen sein. Fig. 1 zeigt in einer schematischen Schaltbilddarstellung einen Teil des Herds 1, und zwar in Bezug auf das Kochfeld 10. Lediglich beispielhaft sind auf dem Kochfeld 10 die Kochzonen 11, 12, 13, 14 dargestellt.

Fig. 2 zeigt exemplarisch ein schematisches Schaltbild der Kochzone 13. Wie aus Fig. 2 ersichtlich ist, umfasst das Kochfeld 10 den Strahlungsheizkörper, der vorliegend ein einziges Heizelement umfasst, das durch ein eigenes erstes steuerbares elektrisches Schaltelement, das hier als Taktrelais 21 ausgebildet ist, steuerbar ist. Die durch das Taktrelais 21 und das Heizelement der Kochzone 13 gebildete Reihenschaltung ist als eine Funktionseinheit zusammengeschaltet. Die Reihenschaltung ist ferner in Reihe mit einem Temperaturwächter 20 geschaltet (Fig. 3). Fig. 2 zeigt folglich die Kochzone 13 als Funktionseinheit, der ein Heizelement 19 als widerstandselektrisches Funktionselement zugeordnet ist, welches vorliegend durch einen Strahlungsheizkörper gebildet ist. Zum Heizelement 19 ist das Taktrelais 21 als erstes steuerbares elektrisches Schaltelement in Reihe geschaltet, welches durch die Steuereinheit 9 des Haushaltsgeräts 1 mit einem entsprechenden Schaltsignal beaufschlagt wird, damit das Heizelement 19 eine vorgegebene Wärmeenergie erzeugt. Die Steuereinheit 9 ist kommunikationstechnisch auch mit der Bedienvorrichtung 15 sowie den Bedienelementen 17 und 18 sowie den weiteren Einheiten des Herds 1 gekoppelt. Sie folgenden Ausführungen zur Kochzone 13 sind dem Grunde nach entsprechend angepasst auch für die weiteren Kochzonen 11, 12 und 14 anwendbar, weshalb von weiteren detaillierten Ausführungen hierzu abgesehen wird.

Zur Kochzone 13 ist ein Hauptschalter-Relais 22 als zweites steuerbares elektrisches Schaltelement in Reihe geschaltet, welches ebenfalls an die Steuereinheit 9 angeschlossen ist und von dieser mittels eines entsprechenden Schaltsignals beaufschlagt wird. Mittels des Hauptschalter-Relais 22 kann die Kochzone 13 eingeschaltet beziehungsweise ausgeschaltet werden. Das Hauptschalter-Relais 22 dient also vordringlich nicht dazu, die mittlere Leistung des Heizelements 19 im bestimmungsgemäßen Heizbetrieb einzustellen. Im bestimmungsgemäßen Betrieb beaufschlagt die Steuereinheit 9 das Taktrelais 21 und das Hauptschalter-Relais 22 mit entsprechenden Schaltsignalen.

Zur Energieversorgung ist die Reihenschaltung aus der Kochzone 13 und dem Hauptschalter-Relais 22 an einem Energiequellenanschluss 8 des Herds 1 ein Netzspannungsanschluss eines nicht weiter dargestellten öffentlichen Energieversorgungsnetzes angeschlossen. Das Energieversorgungsnetz stellt mittels des Netzspannungsanschlusses eine dreiphasige Wechselspannung bereit, über den dem Herd 1 elektrische Energie zuführbar ist. Die Kochzone 13 ist vorliegend lediglich mit einer einzigen der drei Phasen elektrisch gekoppelt.

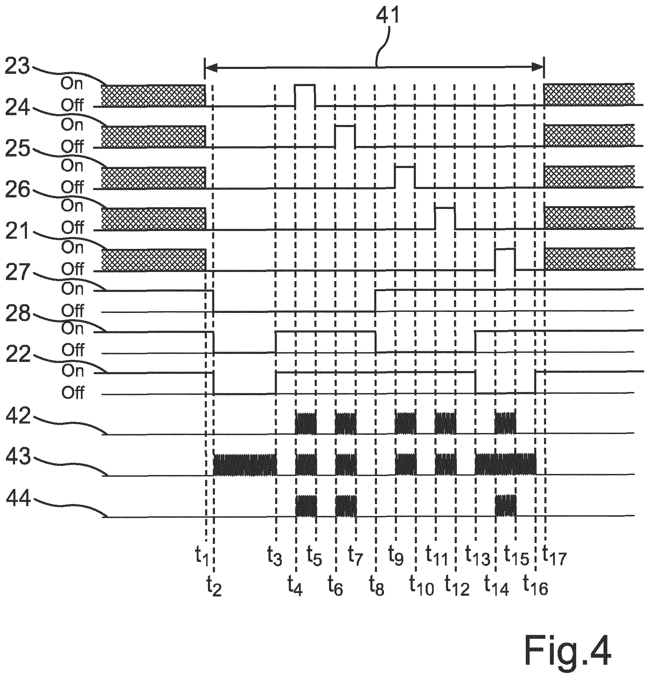

Parallel zum Hauptschalter-Relais 22 ist an einem Mittelanschluss 30 und an einem elektrischen Bezugspotential N des Netzspannungsanschlusses ein Spannungssensor 29 angeschlossen, der mit der Steuereinheit 9 signaltechnisch gekoppelt ist. Über eine Auswertung eines vom Spannungssensor 29 bereitgestellten Sensorsignals in einem durch die Steuereinheit 9 vorgebbaren Testzeitraum 41 (Fig. 4), in dem die Steuereinheit 9 das Taktrelais 21 und das Hauptschalter-Relais 22 mit geeigneten Schaltsignalen beaufschlagt, die sich zeitlich teilweise überlappen, kann die Funktionsfähigkeit des Taktrelais 21 sowie des Hauptschalter-Relais 22 bestimmt werden, wie im Folgenden noch weiter erläutert werden wird.

Fig. 3 zeigt nun in einer schematischen Schaltbilddarstellung wie Fig. 2 einen Ausschnitt in Bezug auf das Kochfeld 10 gemäß Fig. 1. Wie aus Fig. 3 ersichtlich ist, sind vorliegend die lediglich Kochzonen 11, 12, 13 schaltungstechnisch dargestellt. Entsprechendes gilt jedoch auch für die nicht dargestellte Kochzone 14.

Zu erkennen ist aus Fig. 3, dass das Kochfeld 10 die Kochzonen 11, 12, 13, 14 (in Fig. 3 nicht dargestellt) als Funktionseinheiten umfasst. Die Kochzone 11 umfasst zwei Heizelemente 33, 34, zu denen jeweils ein Taktrelais 23, 24 in Reihe geschaltet ist. Die hierdurch gebildeten beiden Reihenschaltungen sind innerhalb der Kochzone 11 parallelgeschaltet. In Reihe zu der Parallelschaltung ist ferner ein Temperaturwächter 20 geschaltet, der ebenfalls von der Kochzone 11 umfasst ist.

In Reihe zu der Kochzone 11 ist ferner das Hauptschalter-Relais 27 geschaltet. Diese Reihenschaltung ist vorliegend an einen Phasenanschluss L1 eines Energiequellenanschlusses 8 und an einen Nullanschluss N des Energiequellenanschlusses 8 angeschlossen, an dem die dreiphasige Wechselspannung anliegt. Die Taktrelais 23, 24 sowie das Hauptschalter-Relais 27 sind an die Steuereinheit 9 angeschlossen und werden von dieser mit entsprechenden Schaltsignalen beaufschlagt.

Der gleiche Aufbau gilt dem Grunde nach auch für die Kochzone 12, die ebenfalls zwei Heizelemente 35 und 36 umfasst, die jeweils in Reihe geschaltet mit einem jeweiligen Taktrelais 25, 26 sind. Die Reihenschaltungen sind auch hier wieder parallelgeschaltet, wobei die hierdurch gebildete Parallelschaltung in Reihe zu einem weiteren Temperaturwächter 20 der Kochzone 12 geschaltet ist. Die Kochzone 12 ist ferner in Reihe geschaltet zu einem Hauptschalter-Relais 28.

Die Kochzone 13 entspricht hinsichtlich ihres Aufbaus dem, was bereits zur Fig. 2 vorgetragen wurde, weshalb diesbezüglich auf die entsprechenden Ausführungen verwiesen wird. Ergänzend ist auch hier der Temperaturwächter 20 für die Kochzone 13 dargestellt. Entsprechendes wie für die Kochzone 13 gilt vorliegend auch für die Kochzone 14, auch wenn dies aus Fig. 3 nicht ersichtlich ist. Bei alternativen Ausgestaltungen können die Kochzonen 11, 12, 13, 14 natürlich auch anders realisiert sowie auch angeordnet sein und beispielsweise auch mehr als zwei Heizelemente umfassen. In einem solchen Fall umfasst die jeweilige Kochzone dann auch eine entsprechende Anzahl von Taktrelais.

Durch elektrische Verbindungen der Kochzonen beziehungsweise der elektrischen Funktionseinheiten 11, 12, 13, 14 mit den jeweiligen Hauptschalter-Relais 22, 27, 28 werden entsprechende Mittelanschlüsse 30, 31, 32 gebildet. Für die Kochzone 14 ist dies zwar nicht dargestellt, es gilt jedoch entsprechendes.

An diese Mittelanschlüsse 30, 31, 32 sind Erfassungszweige 37 des Spannungssensors 29 angeschlossen, und zwar mit einem jeweiligen Erfassungsanschluss. Jeweilige, den Erfassungsanschlüssen gegenüberliegende Anschlüsse der Erfassungszweige 37 sind an einem Mittelanschluss 45 elektrisch miteinander gekoppelt, welcher an einen ersten Anschluss eines elektrischen Widerstands 39 angeschlossen ist, der seinerseits mit einem gegenüberliegenden zweiten Anschluss an das Bezugspotential N angeschlossen ist. Die Erfassungszweige 37 umfassen jeweils eine Reihenschaltung aus einem Widerstand 38 sowie einer Diode 40, sodass ein Spannungsteiler gebildet wird, der zugleich rückwirkungsfrei bezüglich der Mittelanschlüsse 30, 31, 32 ist. Am Widerstand 39 ist dann ein Signaleingang der Steuereinheit 9 angeschlossen, wodurch der Spannungssensor 29 mit der Steuereinheit 9 signaltechnisch gekoppelt ist.

Fig. 4 zeigt in einer schematischen Signaldarstellung Steuersignale für die in Fig. 3 dargestellten elektrischen Schaltelemente 21 bis 28 in einem Testzeitraum 41, um die Funktionsfähigkeit dieser elektrischen Schaltelemente 21 bis 28 zu bestimmen. Die Bestimmung der Funktionsfähigkeit wird mittels der Steuereinheit 9 ausgeführt. Um die Zuordnung zu erleichtern, sind die in Fig. 4 genutzten Bezugszeichen den jeweiligen Schaltelementen zugeordnet, das heißt, die dort genutzten Bezugszeichen entsprechen den Signalen der entsprechend zugehörigen Schaltelemente. Im Folgenden wird zunächst die Durchführung des Verfahrens sowie das Ergebnis für eine intakte Funktionalität der elektrischen Schaltelemente 21 bis 28 beschrieben.

Aus Fig. 4 ist ersichtlich, dass der Testzeitraum 41 während des bestimmungsgemäßen Betriebs des Kochfelds 10 vorgesehen wird, indem der bestimmungsgemäße Betrieb des Kochfelds 10 unterbrochen wird. Zu diesem Zweck werden die Schaltsignale für die Taktrelais 21, 23, 24, 25, 26 zu einem Zeitpunkt t₁ deaktiviert, sodass diese Relais ausgeschaltet sind. Zu einem kurz darauffolgenden Zeitpunkt t₂ werden dann die Hauptschalter-Relais 22, 27, 28 ebenfalls ausgeschaltet. Anhand des Graphen 42 ist ersichtlich, dass das entsprechende Sensorsignal, welches an die Steuereinheit 9 übermittelt wird (Fig. 3), 0 V beträgt.

Zu einem folgenden Zeitpunkt t₃ werden die Hauptschalter-Relais 22, 28 durch die Steuereinheit 9 eingeschaltet, wobei das Hauptschalter-Relais 27 zunächst ausgeschaltet bleibt. Zu einem auf t₃ folgenden Zeitpunkt t₄ wird das Taktrelais 23 bis zum darauffolgenden Zeitpunkt t₅ eingeschaltet. Aus dem Graphen 42 ist ersichtlich, dass ein entsprechendes Spannungssignal an die Steuereinheit übermittelt wird.

Zu einem auf den Zeitpunkt t₅ folgenden Zeitpunkt t₆ wird dann bis zum Zeitpunkt t₇ das Taktrelais 24 eingeschaltet. Ein entsprechender Signalverlauf ergibt sich anhand des Graphen 42.

Zum Zeitpunkt t₈ wird dann das Hauptschalter-Relais 28 ausgeschaltet und stattdessen das Hauptschalter-Relais 27 eingeschaltet. Dadurch ist nunmehr die Prüfung in Bezug auf die Kochzone 11 abgeschlossen und es erfolgt die Prüfung in Bezug auf die Kochzone 12.

Zum Zeitpunkt tg wird das Taktrelais 25 eingeschaltet bis zu einem Zeitpunkt t₁₀. Der Graph 42 zeigt einen entsprechenden Signalverlauf. Zu einem Zeitpunkt t₁₁, der auf den Zeitpunkt t₁₀ folgt, wird das Taktrelais 26 bis zum Zeitpunkt t₁₂ eingeschaltet. Der Graph 42 zeigt wieder ein entsprechendes Signal.

Zum Zeitpunkt t₁₃ wird das Hauptschalter-Relais 28 eingeschaltet und das Hauptschalter-Relais 22 ausgeschaltet. Die Prüfung der Kochzone 12 ist somit beendet und es erfolgt nun die Prüfung der Kochzone 13.

Zum Zeitpunkt t₁₄ wird das Taktrelais 21 bis zum Zeitpunkt t₁₅ eingeschaltet, zu dem es wieder ausgeschaltet wird. Der Graph 42 zeigt einen entsprechenden Signalverlauf für das Sensorsignal. Zum Zeitpunkt t₁₆ wird sodann das Hauptschalter-Relais 22 wieder eingeschaltet. Kurz danach ist die Testphase zum Zeitpunkt t₁₇ beendet und der bestimmungsgemäße Betrieb wird wiederaufgenommen. Für die Kochzone 14 kann eine entsprechende Funktionsprüfung vorgesehen werden.

Anhand des Graphen 42 ist ersichtlich, dass die elektrischen Schaltelemente und deren Ansteuerung funktionstüchtig sind und in bestimmungsgemäßer Weise funktionieren. Das Kochfeld 10 sowie die entsprechende Steuerung sind somit intakt.

Mit dem Graphen 43 ist das Sensorsignal dargestellt, und zwar für den Fall, dass das Taktrelais 21 defekt ist und einen klebenden Kontakt aufweist. Das Taktrelais 21 ist somit permanent eingeschaltet, und zwar unabhängig vom Schaltsignal der Steuereinheit 9. Zu erkennen ist, dass im Zeitraum zwischen t₂ und t₃ eine Spannung erfasst wird, die am Mittelanschluss 30 vom Spannungssensor 29 anliegt. Entsprechend stellt der Spannungssensor 29 das Sensorsignal für die Steuereinheit 9 bereit. Zu diesem Zeitraum sollte die Spannung bei intakten elektrischen Schaltelementen null sein. Darüber hinaus zeigt sich, dass während des Zeitraums t₁₃ bis t₁₆ ebenfalls kontinuierlich eine Spannung am Mittelanschluss 30 erfasst werden kann. Daraus kann die Steuereinheit 9 ermitteln, dass das Taktrelais 21 defekt ist und einen Kurzschluss bereitstellt.

Der Graph 44 zeigt einen entsprechenden Signalverlauf des vom Spannungssensor 29 bereitgestellten Sensorsignals, wenn das Hauptschalter-Relais 28 defekt ist und permanent eingeschaltet bleibt, und zwar unabhängig vom Schaltsignal der Steuereinheit 9. Zu erkennen ist, dass entsprechend in den Zeiträumen tg bis t₁₀ sowie t₁₁ bis t₁₂ keine Spannungen durch den Spannungssensor 29 am Mittelanschluss 32 erfasst werden. Dadurch kann die Steuereinheit ermitteln, dass das Hauptschalter-Relais 28 defekt ist und dauerhaft eingeschaltet ist.

Mittels der Erfindung ist es also möglich, dass die Steuereinheit 9 die Funktionalität der elektrischen Schaltelemente und deren Ansteuerung bestimmt beziehungsweise überwacht. Wird ein defektes elektrisches Schaltelement ermittelt, kann die Steuereinheit 9 zum Beispiel ein entsprechendes Meldesignal abgeben. Darüber hinaus kann die Steuereinheit 9 zum Beispiel die entsprechende Kochzone dauerhaft deaktivieren, um gefährliche Zustände zu vermeiden. Nach dem gleichen Prinzip wie zuvor erläutert können auch die weiteren Taktrelais beziehungsweise Hauptschalter-Relais hinsichtlich ihrer Funktionstüchtigkeit überwacht werden.

In den vorliegenden Ausführungsbeispielen, die sich auf Kochfelder mit Strahlungsheizkörpern beziehen, werden Schaltrelais verwendet, um die bestimmungsgemäße Funktion, insbesondere die Leistungseinstellung, zu realisieren. Jeder der Strahlungsheizkörper beziehungsweise jedes der Heizelemente wird dabei von zwei unabhängigen Relais geschaltet. Eines der Relais wird in der Regel als Hauptschalter-Relais genutzt und das zweite der Relais dient als Taktrelais. Das Taktrelais wird mit variablem Taktverhältnis in Bezug auf eine Einschaltzeit und eine Ausschaltzeit gesteuert, um dadurch eine mittlere Leistung einstellen zu können. Insbesondere muss das Taktrelais eine ausreichende Schalthäufigkeit realisieren können, damit innerhalb einer vorgegebenen Lebensdauer des Kochfelds keine Funktionsstörung auftritt. Insbesondere am Ende der prognostizierten Lebensdauer kommt es häufig vor, dass ein Taktrelais im eingeschalteten Zustand verbleibt, weil sein Kontakt klebt. Dadurch ist das Heizelement der entsprechenden Kochzone permanent eingeschaltet. Sicherheitstechnisch braucht dies ein Problem zu sein, weil ein Abschalten über das Hauptschalter-Relais weiterhin möglich ist und zudem ein Temperaturbegrenzer vorgesehen ist. Die Ansteuerung der Relais wird in der Regel sicherheitstechnisch überwacht, um Fehlansteuerungen zu erkennen und gefährliche Betriebszustände zu vermeiden. Dabei gelten die üblicherweise verwendeten Relais als funktionssichere Bauteile.

In Bezug auf Fig. 2 wird das Heizelement 19 über die beiden Relais 21 und 22 mit der Energiequelle, die am Energiequellenanschluss 8 angeschlossen ist, elektrisch gekoppelt. Der Spannungssensor 29 erfasst die Spannung am Hauptschalter-Relais 22 und die Steuereinheit 9 beurteilt anhand von Sollzuständen der Relais 21, 22, ob der Zustand in Ordnung ist oder ob ein Fehler vorliegt. Ist das Taktrelais 21 fälschlicherweise geschlossen, kann dies einfach detektiert werden, indem das Hauptschalter-Relais 22 kurzzeitig geöffnet wird. Wird bei ausgeschalteten Relais 21, 22 eine Spannung detektiert, so kann daraus geschlossen werden, dass das Taktrelais 21 trotz fehlendem Schaltsignals eingeschaltet ist. In gleicher Weise kann die Funktion des Hauptschalter-Relais 22 bestimmt werden. Hier kann das Taktrelais 21 kurzzeitig eingeschaltet werden. Wird keine Spannung detektiert, so ist entweder das Taktrelais 21 defekt, weil es nicht einschaltet, oder das Hauptschalter-Relais 22 schaltet nicht aus.

Die Steuereinheit 9 kann in den vorgenannten Fällen durch Verknüpfung der Schaltsignale mit dem Sensorsignal kritische Fehler erkennen und beide Relais 21, 22 ausschalten, sodass die entsprechende Kochzone 13 im sicheren Zustand ist.

Sollte es zweckmäßig sein, das Sensorsignal galvanisch von einem Potential der Steuereinheit zu trennen, kann dies mit geeigneten Mitteln, beispielsweise einem Optokoppler oder dergleichen, erreicht werden.

In Bezug auf Fig. 4 kann ferner ergänzt werden, dass zu Beginn des Testzeitraums 41 zunächst alle Relais 21 bis 28 ausgeschaltet werden. Es darf dann kein Sensorsignal detektiert werden. Als nächstes werden die zwei Hauptschalter-Relais 22 und 28 eingeschaltet und die Taktrelais 23, 24 werden kurz nacheinander für eine kurze Zeit eingeschaltet. Daraufhin wird das Hauptschalter-Relais 27 eingeschaltet und das Hauptschalter-Relais 28 ausgeschaltet. Anschließend werden die Taktrelais 25, 26 für eine kurze Zeit nacheinander eingeschaltet. Daraufhin wird das Hauptschalter-Relais 28 eingeschaltet und das Hauptschalter-Relais 22 wieder eingeschaltet und der Testzeitraum 41 ist beendet und der normale, bestimmungsgemäße Betrieb wird wiederaufgenommen.

Ergibt sich ein Signalverlauf des Sensorsignals gemäß dem Graphen 42, liegt kein Fehler vor. Die Signalverläufe der Graphen 43 und 44 entsprechen - wie zuvor bereits erläutert - einem jeweiligen Fehler.

Die Steuereinheit 9 kann die vom Spannungssensor 29 bereitgestellten Verläufe des Sensorsignals mit vorgegebenen Soll-Signalverläufen vergleichen und daraus auf mögliche Fehler der elektrischen Schaltelemente 21 bis 28 schließen.

Die Ausführungsbeispiele dienen ausschließlich der Erläuterung der Erfindung und sollen diese nicht beschränken. Insbesondere ist die Erfindung nicht auf die Anwendung bei Kochfeldern beschränkt. Sie kann dem Grunde nach bei beliebigen elektrischen Haushaltsgeräten zum Einsatz kommen, bei den elektrisch Wärme erzeugt wird, also beispielsweise auch bei einem Backofen, aber auch bei Waschmaschinen, Geschirrspülmaschinen und/oder dergleichen.

### Bezugszeichenliste

- 1: Herd
- 2: Gehäuse
- 3: Muffel
- 4: Backofen
- 5: Tür
- 6: Frontscheibe
- 7: Türgriff
- 8: Energiequellenanschluss
- 9: Steuereinheit
- 10: Kochfeld
- 11: Kochzone
- 12: Kochzone
- 13: Kochzone
- 14: Kochzone
- 15: Bedienvorrichtung
- 16: Anzeigeeinheit
- 17: Bedienelement
- 18: Bedienelement
- 19: Heizkörper
- 20: Temperaturwächter
- 21: Taktrelais
- 22: Hauptschalter-Relais
- 23: Taktrelais
- 24: Taktrelais
- 25: Taktrelais
- 26: Taktrelais
- 27: Hauptschalter-Relais
- 28: Hauptschalter-Relais
- 29: Spannungssensor
- 30: Mittelanschluss
- 31: Mittelanschluss
- 32: Mittelanschluss
- 33: Heizkreis I
- 34: Heizkreis II
- 35: Heizkreis I
- 36: Heizkreis II
- 37: Erfassungszweig
- 38: Widerstand
- 39: Widerstand
- 40: Diode
- 41: Testzeitraum
- 42: Graph
- 43: Graph
- 44: Graph
- 45: Mittelanschluss
- L1: Phase
- L2: Phase
- L3: Phase
- N: Nullleiter
- t₁ bis t₁₇: Zeitpunkte

## Patentansprüche

1. Haushaltsgerät (1) mit einer elektrischen Funktionseinheit (11, 12, 13, 14), die wenigstens ein widerstandselektrisches Funktionselement (19, 33, 34, 35, 36) und ein zum wenigstens einen Funktionselement (19, 33, 34, 35, 36) in Reihe geschaltetes erstes steuerbares elektrisches Schaltelement (21, 23, 24, 25, 26) aufweist, einem zweiten steuerbaren elektrischen Schaltelement (22, 27, 28), das zur elektrischen Funktionseinheit (11, 12, 13, 14) in Reihe geschaltet ist, und einer zumindest mit dem wenigstens einen ersten und dem zweiten elektrischen Schaltelement (21, 22, 23, 24, 25, 26, 27, 28) elektrisch gekoppelten Steuereinheit (9) zum Steuern des wenigstens einen ersten und des zweiten elektrischen Schaltelements (21, 22, 23, 24, 25, 26, 27, 28), wobei die aus der Funktionseinheit (11, 12, 13, 14) und dem zweiten steuerbaren elektrischen Schaltelement (22, 27, 28) gebildete Reihenschaltung mit einer elektrischen Energiequelle elektrisch koppelbar ist, **dadurch gekennzeichnet, dass** an einem durch eine elektrische Verbindung der elektrischen Funktionseinheit (11, 12, 13, 14) mit dem zweiten steuerbaren elektrischen Schaltelement (22, 27, 28) gebildeten Mittelanschluss (30, 31, 32) ein mit der Steuereinheit (9) signaltechnisch gekoppelter Spannungssensor (29) angeschlossen ist, wobei die Steuereinheit (9) ausgebildet ist, in einem vorgebbaren Testzeitraum (41) das wenigstens eine erste steuerbare elektrische Schaltelement (21, 23, 24, 25, 26) und das zweite steuerbare elektrische Schaltelement (22, 27, 28) mit vorgebbaren Schaltsignalen zu beaufschlagen, die sich zeitlich teilweise überlappen, und ein Sensorsignal des Spannungssensors (29) unter Berücksichtigung der Schaltsignale auszuwerten.

2. Haushaltsgerät nach Anspruch 1, **dadurch gekennzeichnet, dass** der Spannungssensor (29) ausgebildet ist, eine elektrische Spannung zwischen dem Mittelanschluss (30, 31, 32) und einem vorgebbaren elektrischen Bezugspotential (N) zu erfassen, wobei das elektrische Bezugspotential vorzugsweise durch ein von wenigstens zwei elektrischen Potentialen eines Energiequellenanschlusses (8) zum elektrischen Koppeln der Energiequelle gebildet ist.

3. Haushaltsgerät nach einem der vorhergehenden Ansprüche, **dadurch gekennzeichnet, dass** der Spannungssensor (29) einen wenigstens zwei elektrische Widerstände (38, 39) aufweisenden Spannungsteiler umfasst.

4. Haushaltsgerät nach einem der vorhergehenden Ansprüche, **dadurch gekennzeichnet, dass** die Funktionseinheit (11, 12, 13, 14) wenigstens zwei widerstandselektrische Funktionselemente (33, 34, 35, 36) und zu jedem der wenigstens zwei Funktionselemente ein jeweiliges in Reihe geschaltetes erstes steuerbares elektrisches Schaltelement (23, 24, 25, 26) aufweist, wobei die hierdurch gebildeten Reihenschaltungen parallelgeschaltet sind.

5. Haushaltsgerät nach einem der vorhergehenden Ansprüche, **gekennzeichnet durch** wenigstens zwei elektrische Funktionseinheiten (11, 12, 13, 14), wobei zu jeder der wenigstens zwei elektrischen Funktionseinheiten (11, 12, 13, 14) ein jeweiliges zweites steuerbares elektrisches Schaltelement (22, 27, 28) in Reihe geschaltet ist.

6. Haushaltsgerät nach Anspruch 5, **dadurch gekennzeichnet, dass** der Spannungssensor (29) ausgebildet ist, an jeweiligen Mittelanschlüssen (30, 31, 32) der durch die jeweiligen Funktionseinheiten (11, 12, 13, 14) und die jeweiligen zweiten steuerbaren elektrischen Schaltelemente (22, 27, 28) gebildeten Reihenschaltungen die jeweiligen elektrischen Spannungen zu erfassen.

7. Haushaltsgerät nach Anspruch 6, **dadurch gekennzeichnet, dass** der Spannungssensor (29) zum Erfassen der jeweiligen Spannungen jeweilige an die jeweiligen Mittelanschlüsse (30, 31, 32) mit einem jeweiligen Erfassungsanschluss angeschlossene Erfassungszweige (37) aufweist, wobei die Erfassungszweige (37) jeweils wenigstens eine Diode (40) umfassen.

8. Haushaltsgerät nach Anspruch 7, **dadurch gekennzeichnet, dass** die Erfassungszweige (37) an den jeweiligen Erfassungsanschlüssen gegenüberliegenden Anschlüssen elektrisch miteinander gekoppelt sind.

9. Verfahren zum Betreiben eines Haushaltsgeräts (1) mit einer elektrischen Funktionseinheit (11, 12, 13, 14), die wenigstens ein widerstandselektrisches Funktionselement (19, 33, 34, 35, 36) und ein zum wenigstens einen Funktionselement (19, 33, 34, 35, 36) in Reihe geschaltetes erstes steuerbares elektrisches Schaltelement (21, 23, 24, 25, 26) aufweist, einem zweiten steuerbaren elektrischen Schaltelement (22, 27, 28), das zur elektrischen Funktionseinheit (11, 12, 13, 14) in Reihe geschaltet ist, wobei das wenigstens eine erste und das zweite elektrische Schaltelement (21, 22, 23, 24, 25, 26, 27, 28) mittels einer mit dem wenigstens einen ersten und dem zweiten elektrischen Schaltelement (21, 22, 23, 24, 25, 26, 27, 28) gekoppelten Steuereinheit (9) gesteuert werden, wobei die aus der Funktionseinheit (11, 12, 13, 14) und dem zweiten elektrischen Schaltelement (22, 27, 28) gebildete Reihenschaltung mit einer elektrischen Energiequelle elektrisch gekoppelt wird, **dadurch gekennzeichnet, dass** an einem durch eine elektrische Verbindung der elektrischen Funktionseinheit (11, 12, 13, 14) mit dem zweiten steuerbaren elektrischen Schaltelement (22, 27, 28) gebildeten Mittelanschluss (30, 31, 32) eine elektrische Spannung erfasst wird, wobei das wenigstens eine erste steuerbare elektrische Schaltelement (21, 23, 24, 25, 26) und das zweite steuerbare elektrische Schaltelement (22, 27, 28) in einem vorgebbaren Testzeitraum (41) mit vorgebbaren Schaltsignalen beaufschlagt werden, die sich zeitlich teilweise überlappen, und die erfasste elektrische Spannung unter Berücksichtigung der Schaltsignale ausgewertet wird.

10. Verfahren nach Anspruch 9, **dadurch gekennzeichnet, dass** die elektrische Spannung zwischen dem Mittelanschluss (30, 31, 32) und einem vorgebbaren elektrischen Bezugspotential (N), insbesondere einem von wenigstens zwei elektrischen Potentialen der Energiequelle, erfasst wird.

11. Verfahren nach einem der Ansprüche 9 oder 10, **dadurch gekennzeichnet, dass** die Funktionseinheit (11, 12) wenigstens zwei widerstandselektrische Funktionselemente (33, 34, 35, 36) und zu jedem der wenigstens zwei Funktionselemente (33, 34, 35, 36) ein jeweiliges in Reihe geschaltetes erstes steuerbares elektrisches Schaltelement (23, 24, 25, 26) aufweist, wobei die hierdurch gebildeten Reihenschaltungen parallelgeschaltet sind, wobei die Schaltsignale für die wenigstens zwei ersten steuerbaren elektrischen Schaltelemente (23, 24, 25, 26) zeitlich voneinander beabstandet sind.

12. Verfahren nach einem der Ansprüche 9 bis 11, **dadurch gekennzeichnet, dass** das Haushaltsgerät (1) wenigstens zwei elektrische Funktionseinheiten (11, 12, 13, 14) aufweist, wobei zu jeder der wenigstens zwei elektrischen Funktionseinheiten (11, 12, 13, 14) ein jeweiliges zweites steuerbares elektrisches Schaltelement (22, 27, 28) in Reihe geschaltet ist, mittels welchem die jeweilige Funktionseinheit (11, 12, 13, 14) gesteuert wird.

13. Verfahren nach Anspruch 12, **dadurch gekennzeichnet, dass** die wenigstens zwei elektrischen Funktionseinheiten (11, 12, 13, 14) getrennt voneinander mit elektrischer Energie versorgt werden.

14. Verfahren nach einem der Ansprüche 12 oder 13, **dadurch gekennzeichnet, dass** der Spannungssensor (29) die an den Mittelanschlüssen (30, 31, 32) erfassten Spannungen voneinander elektrisch entkoppelt erfasst.

15. Verfahren nach einem der Ansprüche 9 bis 14, **dadurch gekennzeichnet, dass** der bestimmungsgemäße Betrieb des Haushaltsgeräts (1) während des Testzeitraums (41) unterbrochen ist.
